# EUROPEAN PATENT SPECIFICATION

(11) **EP 4 621 828 B1**
(45) Date of publication and mention of the grant of the patent: **30.09.2026**
(21) Application number: 24164358.4
(22) Date of filing: 19.03.2024
(51) Int. Cl.: H10D 64/01

(54) **METHOD FOR FORMING A CONTACT FOR A SEMICONDUCTOR DEVICE, AND A CONTACT FOR A SEMICONDUCTOR DEVICE**
VERFAHREN ZUR HERSTELLUNG EINES KONTAKTS FÜR EIN HALBLEITERBAUELEMENT UND KONTAKT FÜR EIN HALBLEITERBAUELEMENT
PROCÉDÉ DE FORMATION D'UN CONTACT POUR UN DISPOSITIF SEMI-CONDUCTEUR ET CONTACT POUR UN DISPOSITIF SEMI-CONDUCTEUR

(43) Date of publication of application: 24.09.2025
(73) Proprietor: Imec VZW, 3001 Leuven (BE); Katholieke Universiteit Leuven KU Leuven Research & Development, 3000 Leuven (BE)
(72) Inventor: EVERAERT, Jean-Luc, 3052 Blanden (BE); SANKARAN, Kiroubanand, 3020 Herent (BE); POLLEFLIET, Bert, 8000 Brugge (BE); PORRET, Clement, 3010 Kessel-Lo (BE); ROSSEEL, Erik, 1390 Grez-Doiceau (BE)
(74) Representative: AWA Sweden AB

(56) References cited:
- US-A1- 2021 391 224
- US-A1- 2023 378 305
- POLLEFLIET BERT ET AL: "Crystallinity and composition of Sc 1-x(-y) Si x (P y ) silicides in annealed TiN / Sc / Si:P stacks for advanced contact applications", 6 February 2024 (2024-02-06), JP, XP093179553, ISSN: 0021-4922, Retrieved from the Internet <URL:https://iopscience.iop.org/article/10.35848/1347-4065/ad1f0d/pdf> DOI: 10.35848/1347-4065/ad1f0d
- PORRET C ET AL: "Low temperature source/drain epitaxy and functional silicides: essentials for ultimate contact scaling", 2022 INTERNATIONAL ELECTRON DEVICES MEETING (IEDM), IEEE, 3 December 2022 (2022-12-03), XP034280945, DOI: 10.1109/IEDM45625.2022.10019501

## Description

### TECHNICAL FIELD

The present disclosure relates to method for forming a semiconductor device, and a contact for a semiconductor device.

### BACKGROUND

A dynamic random-access memory (DRAM) is a semiconductor device for storing a plurality of bits in respective DRAM cells. Each DRAM cell is associated with a transistor and may also be associated with a capacitor for storing the bit. The DRAM may additionally comprise peripheral logic, e.g. comprise further transistors. During production of the DRAM, one or more annealing steps may be performed. The document "Crystallinity and composition of Sc1-x-y SixPy silicides in annealed TiN/Sc/Si:P stacks for advanced contact applications" by Polletfliet et al. describes Sc-based contacts on Si:P and show strong promise for NMOS. This study reveals their structure after annealing: an orthorhombic ScSi layer forms atop a thin Sc-Si-P interfacial layer that aligns well with the Si:P substrate, potentially minimizing interface defects. The ScSi phase remains stable from ~450-700 °C, but added thermal budget in this range can degrade contact performance, shedding light on the mechanisms behind this deterioration.

The document US2021391224 A1 describes a semiconductor device with two types of vertical transistors, each built on fins and using source/drain regions formed by selective growth. The two transistor regions use different silicide compositions, created through separate silicidation steps. The method details how dielectric layers are patterned to expose fins and form distinct silicide contacts for n-type and p-type devices.

### SUMMARY

<The invention is set out in the appended set of claims.>

It is a realization that scandium provides a high-quality contact to a source/drain region of transistor. It is further a realization that the contact may degrade, e.g. suffer from increased contact resistance, when annealed at high temperature and/or for a long time, e.g. above 500°C for at least one hour. In some circumstances a high thermal budget is desirable, i.e. in some circumstances it is desirable to be able to anneal at high temperature and/or for a long time. An example of such circumstances is the production of DRAM. DRAM cells may benefit from a high-thermal budget anneal, as this may passivate the DRAM cell, which in turn may reduce leakage current. However, when transistors of DRAM peripheral logic (or transistors of the DRAM cells themselves) are subjected to said high-thermal budget anneal, contacts to source/drain regions may degrade. It is a further realization that this effect may be particularly pronounced when the transistors of the peripheral logic are small, since small source/drain regions may have high contact resistance. Such small transistors may be Fin field-effect transistors (FINFETs).

It is an objective of the present inventive concept to provide a method for forming a high-quality contact for a semiconductor device. A further objective is to provide a contact for a semiconductor device having improved electrical characteristics. A further objective is to provide a contact for a semiconductor device which provides a low resistivity. A further objective is to provide a high-quality DRAM, in particular a DRAM comprising transistors with high-quality source/drain contacts. Further and alternative objectives may be understood from the following.

It is a realization that a scandium silicon compound layer on top of a doped silicon layer (such as Si:P; Si:Sb; or Si:As layer) provides a good contact for a source/drain region. Herein, the doping concentration of the doped silicon layer affects the quality of the contact. The scandium silicon compound layer being a ScSiₓP_{y} layer with cubic crystalline structure/symmetry is particularly advantageous. It is a further realization that a scandium layer on a doped silicon layer may, when subjected to a high-thermal budget anneal, react to form a scandium silicon compound layer. However, the process may draw out doping atoms from the doped silicon layer, thereby affecting the doping concentration of the doped silicon layer.

For example, when subjected to a high-thermal budget anneal, a scandium layer on a Si:P layer may react with each other to form a ScSiₓP_{y}, layer on top of a remaining part of the Si:P layer. However, the process may draw out doping atoms from the Si:P layer. Thus, the remaining part of the Si:P layer may have a lower doping concentration than the original Si:P layer.

The inventors have realized that a Si:P layer with a phosphorus concentration of at least 4% (described below as the second layer), underneath the layer comprising scandium (described below as the third layer) is advantageous as the high phosphorous concentration of the second layer facilitates the formation of a ScSiₓP_{y}, layer with cubic crystalline structure and at the same time prevents the scandium from drawing doping atoms from layers below (described below as the first layer).

According to a first aspect of the invention, there is provided a method for forming a contact for a semiconductor device, the contact being an electrical contact to a source/drain region of a transistor, the source/drain region comprising silicon, the method comprising:
forming a first layer on the source/drain region, the first layer comprising at least one of:
   a silicon layer doped with phosphorus, Si:P layer;
   a silicon layer doped with antimony, Si:Sb layer;
   a silicon layer doped with arsenic, Si:As layer;
forming a second layer on top of the first layer, the second layer comprising a silicon layer doped with phosphorus, Si:P layer, a phosphorus concentration of the second layer being at least 4%;
forming a third layer on top of the second layer, the third layer comprising scandium;
forming a capping layer above the third layer, the capping layer being configured to prevent oxidation of the third layer;
performing a first anneal at an anneal temperature above 500°C during an anneal time being at least one hour, the first anneal being performed after said act of forming the capping layer.

The semiconductor device may herein be or comprise a transistor, e.g. a metal-oxide-semiconductor field-effect transistor (MOSFET). The transistor may be a FINFET. The semiconductor device may be a DRAM and will in the following text predominantly be described as such. However, it should be understood that the semiconductor device may be any semiconductor device.

The first, second and third layer, as well as the capping layer, may be referred to as a layer stack. Thus, the method may comprise forming the layer stack. The layer stack may be arranged on a source/drain region comprising silicon. The source/drain region may, for instance, comprise n-doped silicon. The first layer may comprise silicon doped with phosphorus, antimony, or arsenic. The phosphorus, antimony, or arsenic atoms may be active dopants. The second layer may comprise silicon doped with phosphorus. A concentration of phosphorus in the second layer may, for instance, be 10%. The third layer may be a scandium layer. The capping layer comprises a nitride. For example, the capping layer may comprise titanium nitride, TiN. However, it is conceivable that the capping layer may alternatively comprise tantalum nitride, TaN, or scandium nitride, ScN.

The first anneal may be a drive-in anneal, diffusion anneal, or DRAM anneal.

During the first anneal, the third layer may react with the underlying second layer to form a ternary phase, scandium silicon phosphide, ScSiₓP_{y}, layer with cubic crystalline structure/symmetry. It is a realization that the phosphorous of the second layer facilitates the formation of the cubic structure. Thus, a phosphorus concentration of at least 4% in the Si:P layer of the second layer is advantageous. It should be noted that depending on the composition of the second and third layer, the third layer may react with the underlying second layer to form a layer comprising a material other than ScSiₓP_{y}. However, the resulting layer formed after the third layer has reacted with the underlying second layer is hereinafter denoted ScSiₓP_{y} layer for sake of simplicity. The ScSiₓP_{y} layer may be arranged on the first layer such that a physical interface is formed therebetween. That physical interface may be an active interface region further forming part of a metal-semiconductor junction. The metal-semiconductor junction may form a Schottky barrier. The metal-semiconductor junction may comprise the first layer and the ScSiₓP_{y} layer. The ScSiₓP_{y} layer (comprising a metal) may form the metal part of the metal-semiconductor junction. The first layer (comprising a semiconductor material) may form part of the semiconductor part of the metal-semiconductor junction. Charge carriers may flow through the metal-semiconductor junction.

A second layer arranged on top of first layer may prevent active dopants (e.g. P, Sb, or As) initially located in the first layer from being drawn out by the scandium, e.g. being absorbed into the ternary phase ScSiₓP_{y}. To exemplify, consider a situation where the second layer is omitted from the present contact. The third layer comprising a scandium layer may thus be directly deposited on top of the first layer comprising a Si:P 3% layer (and/or Si:Sb layer and/or Si:As layer). Upon anneal, the scandium layer of the third layer reacts with the underlying Si:P 3% layer to form a ternary phase, ScSiₓP_{y} layer, with cubic crystalline structure/symmetry. However, the active phosphorus dopants initially located in the Si:P 3% layer of the first layer gets absorbed into the scandium layer of the third layer. This is problematic for the contact resistivity in that active dopants are drawn out of the active interface region of the Schottky barrier (which is formed by a physical interface between the first layer and the ScSiₓP_{y} layer). Consequently, less active dopants are present at the active interface region. This increases the thickness of the Schottky barrier which in turns reduces the transmission probability for the free carriers. Hence, in the case a second layer in accordance with the present invention is omitted, the contact resistivity is disadvantageously high.

To this end, the present method provides at least the following advantages:
It is a realization that, in order to compensate for the dopant absorption/dopants supplied from the first layer into the third layer, a second layer comprising a comparably high concentration of phosphorus is interposed between the first and third layers. The second layer, rather than the first layer, may chemically react with the third layer and thereby obviate the problem of dopant absorption from the first layer. In other words, the present method may ensure that active dopants are not drawn out of the active interface region. Hence, a high concentration of active dopants may remain at the active interface region. As such, the Schottky barrier may remain thin. The present method also provides a high transmission probability for the free carriers and thus, the contact resistivity may be comparably low.

Furthermore, the ScSiₓP_{y} layer may have a crystalline structure. The ScSiₓP_{y} layer has a lattice constant matching with that of the underlying first layer. This may result in a clean and smooth contact interface and thereby also a high-quality contact, e.g. when ScSixPy aligns epitaxially with Si:P (or Si:Sb, Si;As) in the underlying layer. It may alternatively be said that the ScSiₓP_{y} layer is morphologically and electrically stable upon anneal, e.g. upon the first anneal. This enables a comparably low resistivity, which is advantageous for applications such as advanced DRAM memories.

The capping layer prevents oxidation of the third layer. It may also prevent evaporation of any of the underlying layers during anneal. The capping laying may also provide a low contact resistivity.

The third layer comprises, as discussed above, scandium. It is an advantage that, since scandium is a strong oxygen getter, the capping layer may provide an efficient oxidation barrier and thereby prevent oxidation, e.g. due to a rest fraction of oxygen, H₂O, any oxygen containing compounds or the like being present in the anneal ambient during the first anneal or due to the layer stack being exposed to the atmosphere in between processing, of the third layer comprising scandium during the first anneal. By scandium being a strong oxygen getter, it is generally meant that scandium is prone to react with oxygen and thereby be oxidized during anneal.

The first anneal is performed after the act of forming the capping layer. The first anneal is performed at an anneal temperature anneal temperature above 500°C during an anneal time being at least one hour. Hence, the thermal budget of the first anneal may be said to be 500h°C. The first anneal may be performed at atmospheric pressure. The first anneal may be performed in an inert atmosphere. The inert atmosphere may comprise anneal ambients such as N₂ , Ar or He. For example, the anneal temperature may be 650°C. The anneal time may be 4 hours.

The thermal budget may be in the range of 2600 h°C - 5000 h°C.

It should be understood that, depending on e.g. the processing conditions for the DRAM memory cell, either a low anneal temperature for a long anneal time may be used, or a high anneal temperature for a short anneal time may be used.

Typically, the first anneal is performed at 650°C for 4 hours, i.e. the thermal budget is 650°C * 4 hours = 2600 h°C. Another alternative is that the first anneal is performed at 600°C for 5 hours, i.e. the thermal budget is 600°C * 5 hours = 3000 h°C. Another alternative is that the first anneal is performed at 600°C for 3 hours, i.e. the thermal budget is 600°C * 3 hours = 1800 h°C.

It may in this context be noted that the contact is intended to be formed on a source/drain region on semiconductor device which includes, for instance, a conventional field effect transistor (FET) device.

By the term "thermal budget" it is herein meant, at least as a first approximation, the product of an annealing temperature and an annealing time.

By the term "layer stack" it is herein meant the layers of the contact.

In the context of the present disclosure, a layer being "provided on" another layer generally refers to that the latter layer is arranged "below" the first layer. Thereby, the terms "below"/"above" or "bottom"/"top" relate to layers of the material stack, in particular to the fabrication/growth direction of these layers. In any case, "provided on" means that the layer is in contact with the other layer. For instance, the layer may be (epitaxially) grown on the other layer.

The first aspect of the invention is based on the insight that a second layer comprising a comparably high concentration, for example 10%, of phosphorus interposed between the first layer and the third layer may be seen as sacrificial in the sense that it is configured to react with the third layer during a first anneal so as to prevent dopant absorption from the first layer. In doing so, a high concentration of active dopants may remain at the active interface region defined by a physical interface between the ScSiₓP_{y} layer and the first layer. The second layer is merely intended to react with the third layer and prevent diffusion of active dopants from the first layer. In this way, a thin Schottky barrier may be formed, allowing for a high electron tunnelling probability and thereby a comparably low contact resistivity. Consequently, the electrical characteristics of the semiconductor device are improved. In other words, the second layer is, preferably completely, consumed when reacting with the third layer. The third layer is also consumed when reacting with the second layer. The third layer may be completely consumed when reacting with the second layer.

The phosphorus concentration of the second layer may be in a range of 4-15%.

For instance, the phosphorus concentration of the second layer may be 4%, 5%, 6%, 7%, 8%, 9%, 10%, 11%, 12%, 13%, 14%, or 15%. Such a high concentration of the phosphorus concentration of the second layer may ensure that little to none of the active dopants of the first layer may diffuse into the third layer. Instead, it is ensured that the second layer reacts with the third layer, instead of the first layer reacting with the third layer, and thus the second layer prevents diffusion of active dopants from the first layer to the third layer. Hence, such a phosphorus concentration of the second layer may provide a thin Schottky barrier allowing for a high electron tunnelling probability and thereby a low contact resistivity.

It may in this context be noted that it may be immaterial whether the phosphorus atoms in the second layer are active or inactive dopants. The dopants of the second layer does not necessarily contribute to the functioning of the active interface region. As discussed above, the second layer is merely intended to react with the third layer and prevent diffusion of active dopants from the first layer into the third layer.

A phosphorus concentration of a Si:P layer of the first layer may be within 2-4%.

In other words, the first layer may comprise at least one Si:P layer, wherein a phosphorus concentration of said at least one Si:P layer is within a range of 2-4%. The first layer may additionally comprise a further Si:P layer (e.g. having a phosphorus concentration outside said range) and/or a Si:Sb layer and/or Si:As layer. For instance, the phosphorus concentration of a Si:P layer of the first layer may be 2%, 3%, or 4%. Such a phosphorus concentration enables a sufficiently high concentration of active dopants in the active interface region. Thus, there is provided a high concentration of free carriers which in turn provides a high electron tunnelling probability. Thereby, a low contact resistivity is provided.

The anneal temperature of the first anneal may be above 550°C and the anneal time of the first anneal may be at least 1 h.

This combination of anneal temperature and anneal time ensures that a large amount of phosphorus atoms of the second layer diffuses into the third layer during the first anneal. As such, active dopants from the first layer are prevented from diffusing into the third layer during anneal. **It** is also conceivable that such a combination of anneal temperature and anneal time provides a relatively low thermal budget while still enabling a large amount of phosphorus atoms of the second layer to diffuse into the third layer, while ensuring minimal crystallisation of any dielectric layers in the semiconductor device structure. As discussed above, the present method provides an electrical contact for a source/drain region of a transistor. **It** is generally known that transistors conventionally comprise gate stacks having a dielectric layer to isolate the gate from the semiconductor channel. **In** this context, the combination of the above discussed anneal temperatures and anneal times ensures that the dielectric layers of the gate stacks do not crystallise and hence gate leakage may be reduced.

By way of example, the temperature of the first anneal may be greater than or equal to 550°C, 560°C, 570°C, 580°C, 590°C, 600°C, 610°C, 620°C, 630°C, 640°C, or 650°C.

By way of example, the time of the first anneal may be 2 h, 3 h, or 4 h.

By way of example, the anneal temperature may be 650°C and the anneal temperature may be 4 h. Hence, the thermal budget may be 2600 h°C (650°C * 4 h).

A thickness of the second layer may be at least 2 nm.

Such a thickness may provide a sufficient barrier against diffusion of dopants from the first layer. By way of example, the thickness of the second layer may be 2 nm, at least 3 nm, at least 4 nm, or at least 5 nm. Such a thickness of the second layer may ensure that the entire second layer reacts with the third layer during the first anneal for a given thermal budget while providing a sufficient barrier against diffusion of dopants from the first layer. **In** other words, the second layer may while, preferably, being fully consumed during the first anneal, ensure that the third layer does not react with the first layer since the second layer is arranged between the first layer and the third layer (and may be said to act as a diffusion barrier); and at the time the second layer, preferably, has been fully consumed during the first anneal, also the third layer may have fully reacted with the second layer whereby the reaction therebetween has stopped and thereby the risk that the first layer is consumed during the first anneal is reduced. Further, such a thickness of the second layer may facilitate adequate epitaxial growth of the second layer.

The first and second layers may be epitaxially grown.

This may facilitate formation of crystalline ScSiₓP_{y}, e.g. a ScSiₓP_{y} layer with cubic crystalline structure/symmetry. Further, there is provided an interface between the first and second layers being morphologically and electrically stable. It is also conceivable that the ScSiₓP_{y} crystallites in the ScSiₓP_{y} layer will have a good lattice match with the first layer, and may e.g. epitaxially align with the Si:P (or Si:Sb, Si:As) of first layer during the reaction.

The method may further comprise the act of:
performing a second anneal subsequent to the first anneal, wherein the second anneal is performed at an anneal temperature above 800°C during an anneal time being between 1 ms and 10 s.

The second anneal may be a rapid thermal anneal (RTA). For example, a rapid thermal anneal may be performed at 800°C for 1 s. By way of further example, the anneal temperature may be equal to or greater than 900°C or 1000°C. Rapid thermal anneal by means of laser anneal may be advantageous. For example, laser anneal may be performed at 800 degrees for 1 ms. Further, the second anneal may be performed in an inert atmosphere. The inert atmosphere may comprise anneal ambients such as N₂ , Ar or He.

It is a realization that the first anneal might render a portion of the active dopants in the first layer inactive. Thus, by performing a second anneal, inactive dopants of the first layer may be reactivated.

The combination of the above discussed anneal temperature and anneal time of the second anneal entails a comparably low thermal budget. This is advantageous since an excessively high anneal temperature of the second anneal, and in general an excessively high thermal budget, may negatively affect gate properties, such as the Vₜ (threshold voltage) shift.

The transistor may comprise a fin structure, the source/drain region being in contact with an end surface of the fin structure.

The contact may thus be formed adjacent to the fin structure. The contact may be formed above the fin structure. The fin structure may be interposed between a plurality of contacts, e.g. two contacts. Thus, the transistor may be a FINFET.

The first anneal may be performed after forming, on a same substrate as the transistor, a dynamic random access memory cell, DRAM cell.

It is a realization that the first anneal may be delayed until the DRAM cell has been formed in order to minimize the amount of times the DRAM cell is exposed to anneals.

The third layer may be formed by conformal deposition.

Conformal deposition may be advantageous to form a contact adapted for gate-all-around transistors. Conformal deposition may be performed by Atomic Layer Deposition (ALD) or Chemical Vapor Deposition (CVD). However, the third layer may alternatively be deposited by a conventional deposition method, e.g. Physical Vapor Deposition (PVD).

According to a second aspect of the invention, a contact for a semiconductor device, the contact being an electrical contact for a source/drain region of a transistor, the source/drain region comprising silicon, the contact comprising:
a first layer on the source/drain region, the first layer comprising at least one of:
   a silicon layer doped with phosphorus, Si:P layer;
   a silicon layer doped with antimony, Si:Sb layer;
   a silicon layer doped with arsenic, Si:As layer;
a scandium silicon phosphide layer having a ternary phase with a cubic crystalline structure on top of the first layer.

A capping layer may be arranged above the scandium silicon phosphide layer. The capping layer may be configured to prevent oxidation of layers of the layer stack during processing.

All advantages, features and subject-matter discussed with reference to the method according to the first aspect of the invention may apply also to (and/or be combinable with) the contact according to the second aspect of the invention, and vice versa. For example, the discussion of the layer materials and the doping concentration of each of the layers of the method for forming a contact may apply correspondingly to the layers of the contact formed by the method.

It may be noted that the contact is preferably provided for memory devices, such as DRAM devices, although it may also be provided for other types of devices such as logic semiconductor devices.

Preferably, the first layer comprises a silicon layer doped with phosphorus, Si:P layer. The scandium silicon phosphide, ScSiₓP_{y}, layer may be formed by second layer, which second layer comprises a silicon layer doped with phosphorus, Si:P, reacting with a third layer comprising scandium. The second layer and third layer may be interposed between the first layer and the capping layer, and upon anneal the second and third layers may react with one another and thereby form the scandium silicon phosphide, ScSiₓP_{y}, layer. Preferably, the capping layer comprises titanium nitride, TiN. Thus, there is provided a contact for a semiconductor device having a comparably low resistivity. Consequently, the electrical characteristics of the semiconductor device is improved.

The scandium silicon phosphide layer may have a composition Sc_{1-x-y}SiₓP_{y} wherein y/(x+y) may be greater than 4%.

The ScSiₓP_{y} layer may be formed by the second layer comprising a silicon layer doped with phosphorus, Si:P layer reacting with an adjacent third layer comprising scandium. By y/(x+y) being greater than 4%, it is implied that a phosphorus concentration of the second layer is at least 4%. Such a comparably high concentration of phosphorus of the second layer may ensure that active dopants in the first layer does not diffuse into the third layer.

The transistor may comprise a fin structure, the source/drain region being in contact with an end surface of the fin structure.

The contact may thus be formed adjacent to the fin structure. The contact may be formed above the fin structure. The fin structure may be interposed between a plurality of contacts, e.g. two contacts.

The transistor may be arranged on a same substrate as a dynamic random access memory cell, DRAM cell.

This enables a compact semiconductor device.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings, like reference numerals will be used for like elements unless stated otherwise.
Figs. 1a-b illustrate the contact formation steps of a method applied to a semiconductor device in a schematically depicted cross-sectional view.
Fig. 1c illustrates a plurality of transistors comprising a contact and arranged on a same substrate as a plurality of dynamic random access memory cells, DRAM cells.
Figs. 2a-b illustrate the contact formation steps of an alternate, non-preferred method applied to a semiconductor device in a schematically depicted cross-sectional view.

### DETAILED DESCRIPTION

In the following the formation of a contact will be exemplified in the context of a contact for a DRAM device. More specifically, the contact is arranged on a source/drain region comprising n-doped silicon.

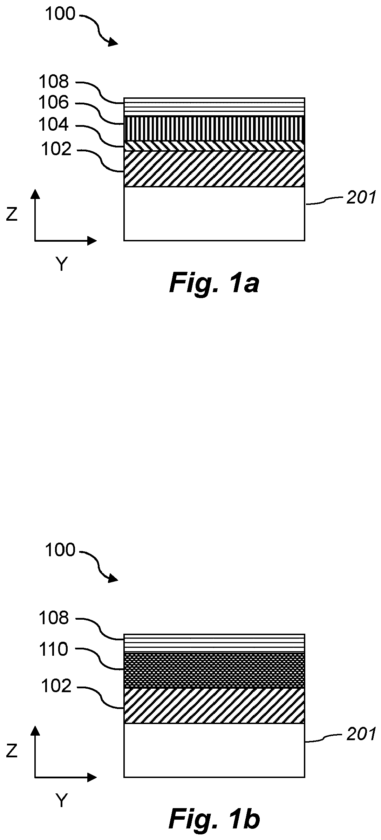

Referring now to Fig. 1a, an initial formation of the contact 100 is illustrated. The contact 100 may be formed on a source/drain region 201. The source/drain region 201 may form part of a semiconductor device, e.g. a complementary metal-oxide semiconductor (CMOS) or a FINFET. The source/drain region 201 may further form part of, for instance, a semiconductor bulk substrate such as a Si substrate, a germanium (Ge) substrate or a silicon-germanium (SiGe) substrate. Other examples include a semiconductor-on-insulator (SOI) type of substrate such as a Si-on-insulator substrate, a Ge-on-insulator substrate or a SiGe-on-insulator substrate. The source/drain region 201 comprises silicon. Preferably, the source/drain region 201 comprises n-doped silicon. The contact 100 may be an electrical contact to the source/drain region 201 of a transistor 200.

Whenever there is a reference to a layer being formed, this is preferably performed using conventional semiconductor fabrication technology, such as metalorganic chemical vapour deposition (MOCVD), physical vapor deposition (PVD), atomic layer deposition (ALD), thin-film deposition, or the like. However, it is conceivable that the layer(s) is formed using conformal deposition. In general, the layers (e.g. the first and second layers 102, 104) of the contact may be epitaxially grown.

In the figures, directions Y and Z indicate a horizontal and a vertical direction, respectively. Direction Z indicates a vertical or bottom-up direction (normal to the source/drain region 201). The figures illustrate a respective cross section of a centre view parallel to the YZ-plane.

The method may further comprise planarizing a top surface of the source/drain region 201. A smooth top surface of the source/drain region 201 may thus be formed. As such, the source/drain region 201 may provide a flat top surface which facilitates forming a layer stack on top of the source/drain region 201. By layer stack it is herein meant the layers of the contact 100. The planarizing of the source/drain region 201 may, for instance, be achieved by chemical mechanical polishing (CMP).

The method further comprises depositing a first layer 102 on the source/drain region 201. The first layer 102 forms a layer arranged on a surface of the source/drain region 201 and parallel therewith. The first layer 102 is configured to be arranged in contact with the source/drain region 201. It is, however, conceivable that there may be arranged an intermediate layer between the first layer 102 and the source/drain region 201.

The first layer 102 is a layer of semiconductor material. The first layer 102 comprises at least one of a silicon layer doped with phosphorus, Si:P layer, a silicon layer doped with antimony, Si:Sb layer, or a silicon layer doped with arsenic, Si:As layer. Preferably, the first layer 102 comprises a Si:P layer. A phosphorus concentration of Si:P layer of the first layer 102 may be within 2-4%. The phosphorus concentration of Si:P layer of the first layer 102 may preferably be 3%. The dopants of the first layer 102 may preferably be active. The first layer 102 may have a thickness being in the range of 10-40 nm. The thickness may e.g. be 10, 20, 30, or 40 nm.

The method further comprises forming a second layer 104 on top of the first layer 102. Thus, the first layer 102 is arranged between the second layer 104 and the source/drain region 201. The second layer 104 is preferably arranged on the first layer 102 such that a physical interface therebetween is formed. However, it is also conceivable that there may be arranged one or more additional layers between the first layer 102 and the second layer 104. In such a case, the second layer 104 may form an interface with an upper most additional layer.

The second layer 104 is a layer of semiconductor material. The second layer 104 comprises a silicon layer doped with phosphorus, Si:P. A phosphorus concentration of the second layer 104 is at least 4%. The phosphorus concentration may be 4%, 5%, 6%, 7%, 8%, 9%, 10%, 11%, 12%, 13%, 14%, or 15%, i.e. in a range of 4-15%.

A thickness of the second layer 104 may at least 2 nm. By way of example, the second layer 104 may be 2 nm, 3 nm, or 4 nm. For example, the thickness may be 5, 6, 7, or 8 nm.

The method further comprises forming a third layer 106 on top of the second layer 104. The third layer 106 is a layer comprising scandium. Scandium is a metal. It is conceivable that the third layer 106 comprises, in addition to scandium, further material, e.g. further metal, depending on the application. In the context of a source/drain region 201 comprising n-doped silicon, the third layer 106 preferably comprises scandium. However, it should be noted that the source/drain region 201 is not restricted to comprising n-doped silicon.

The method further comprises forming a capping layer 108 above the third layer 106. The capping layer 108 may be formed directly on top of the third layer 106 and parallel therewith. The capping layer 108 is configured to prevent oxidation of the third layer 106. As noted above, the third layer 106 may comprise scandium. Scandium is a strong oxygen getter. Should the third layer 106 oxidize, the resistivity of the contact 100 may be negatively affected.

The capping layer 108 comprises a nitride. For example, the capping layer 108 may comprise TiN, TaN, ScN. In particular, by the capping layer 108 comprising TiN there is provided a low resistance and/or provided an efficient oxidation barrier with respect to the third layer 106. It should be noted that the material choice of the capping layer 108 is not confined to a specific material. However, it is preferred that the material of the capping layer 108 provides an efficient oxidation barrier with low resistance. It is conceivable that the formation of the ScSiₓP_{y} layer 110 may be (immediately) followed by in situ formation of metal via's. The capping layer 108 may have a thickness being in the range of 3-15 nm.

Any (subsequent) formation of any features of the contact 100 may involve patterning steps, such as using lithography and etching, which may be provided by equipment readily available at the semiconductor fabrication plant.

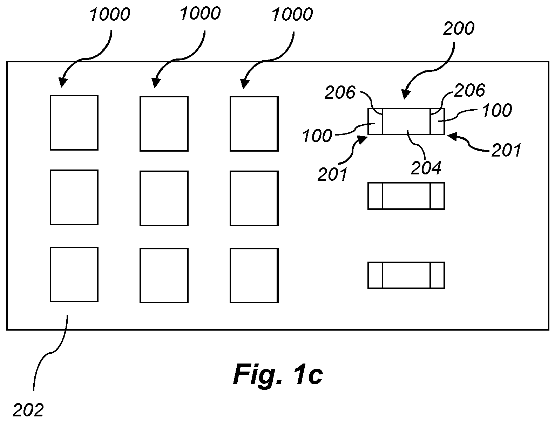

Fig. 1c illustrates an arrangement of DRAM cells 1000 and transistors 200 arranged on a substrate 202, as seen from above. The contact 100 may be a contact to the source/drain region 201 of a fin structure 204 forming part of the transistor 200. The source/drain region 201 may be in contact with an end surface 206 of the fin structure 204. In other words, the contact 100 may be a contact to the source/drain region 201 of a FINFET. The transistor 200 may be arranged on a same substrate 202 as the DRAM cell 1000. Fig. 1c specifically illustrates nine DRAM cells 1000 and three transistors 200. However, it should be noted that the amount of DRAM cells 1000 is not restricted to nine DRAM cells 1000. Nor is the amount of transistors 200 restricted to three transistors 200. The DRAM cells 1000 may be identical. The transistors 200 may be identical.

The transistors 200 may be said to form part of the peripheral logic. As discussed above, the production of DRAM cells may require high-thermal budget anneal in order to passivate the DRAM cells. In doing so, the leakage current may be reduced. However, when transistors of DRAM peripheral logic (or transistors of the DRAM cells themselves) are subjected to said high-thermal budget anneal, contacts to source/drain regions may degrade. It is a realization that this effect may be particularly pronounced when the transistors of the peripheral logic are small, since small source/drain regions may have high contact resistance. Such small transistors may be Fin field-effect transistors (FINFETs). It should be noted that the DRAM cells 1000 may be formed on the substrate 202 after having formed the peripheral logic (transistors 200). Thus, the peripheral logic needs to withstand high-thermal budget anneal of the DRAM cells 1000. The contact 100 according to the present invention is able to withstand such high-thermal budget anneal of the DRAM cells 1000.

Referring now to Fig. 1b, the result of performing a first anneal is illustrated. The method further comprises performing a first anneal (which may be said to be drive-in anneal, diffusion anneal, or DRAM anneal). The first anneal may be performed at atmospheric pressure. The first anneal may be performed in an inert atmosphere. The inert atmosphere may comprise anneal ambients such as N₂ , Ar or He. One purpose with the first anneal is to allow the third layer 106 to react with the underlying second layer 104. Upon the first anneal, the Si:P layer of the second layer 104 reacts with the scandium of the third layer 106, thereby forming a resulting ternary phase, scandium silicon phosphide, ScSiₓP_{y}, layer 110 with cubic crystalline structure/symmetry. The first anneal is performed at an anneal temperature above 500°C during an anneal time being at least one hour. Preferably, the first anneal is performed at an anneal temperature of 650°C during an anneal time being four hours. The first anneal is further being performed after said act of forming the capping layer 108. It should be noted that scandium is a strong oxygen getter. Scandium oxide has a relatively low formation enthalpy. The formation of scandium oxide would result in a contact 100 having high contact resistivity. Hence, the first anneal is advantageously performed after said act of forming the capping layer 108 so as to prevent oxidation of the third layer 106.

The ScSiₓP_{y} layer 110 may be arranged on the first layer 102 such that a physical interface is formed therebetween. That physical interface may be an active interface region further forming part of a metal-semiconductor junction. The metal-semiconductor junction may form a Schottky barrier. The metal-semiconductor junction may comprise the first layer 102 and the ScSiₓP_{y} layer 110. The ScSiₓP_{y} layer 110 (comprising a metal) may form the metal part of the metal-semiconductor junction. The first layer 102 (comprising a semiconductor material) may form part of the semiconductor part of the metal-semiconductor junction. Charge carriers may flow through the metal-semiconductor junction.

As discussed above, the first layer 102 may comprise active dopants. It is a realization that the first anneal might render a portion of the active dopants in the first layer 102 inactive. Thus, by performing a second anneal, inactive dopants of the first layer 102 may be reactivated. The second anneal may therefore be a reactivation anneal. The second anneal may be performed after the first anneal. The second anneal may be performed at an anneal temperature above 800°C during an anneal time between 1 ms and 10 s. In order to reactive dopants in the first layer 102 in the case of a rapid thermal processing (RTP), the anneal should advantageously be performed at a minimal anneal temperature of 800°C during an anneal time of 1 s. It should be noted that a higher anneal temperature, e.g. 1000°C, may reactive more dopants in the first layer 102. However, a lower thermal budget (which may entail a comparably low anneal temperature) is advantageous since an excessively high thermal budget (which may entail a comparably high temperature) may harm gate properties such as the Vt shift. The second anneal/reactivation anneal may be performed by laser anneal, in which case it is envisioned that the laser anneal may be performed at anneal temperature being 800°C during an anneal time of 1 ms. As discussed above, by the term "thermal budget" it is herein meant the product of an annealing temperature and an annealing time.

The ScSiₓP_{y} layer 110 may have a composition Sc_{1-x-y}SiₓP_{y} wherein y/(x+y) is greater than 4%. Hence, by y/(x+y) being greater than 4% it is implied that a phosphorus concentration of the second layer is at least 4%. The ScSiₓP_{y} layer 110 may have a cubic structure. The ScSiₓP_{y} layer 110 may match the lattice of the underlying first layer 102. Consequently, a high-quality contact 100 may be provided. This would also allow to pin the fermi level in accordance with the work function of the ScSiₓP_{y} layer 110, rather than as a consequence of interface states. ScSiₓP_{y} has a lower work function than ScSi and thereby provides a comparably low Schottky barrier height. This results in a lower contact resistivity.

In the following, as an illustrative example, a situation will be discussed where the Si:P layer with phosphorus concentration of at least 4% is omitted.

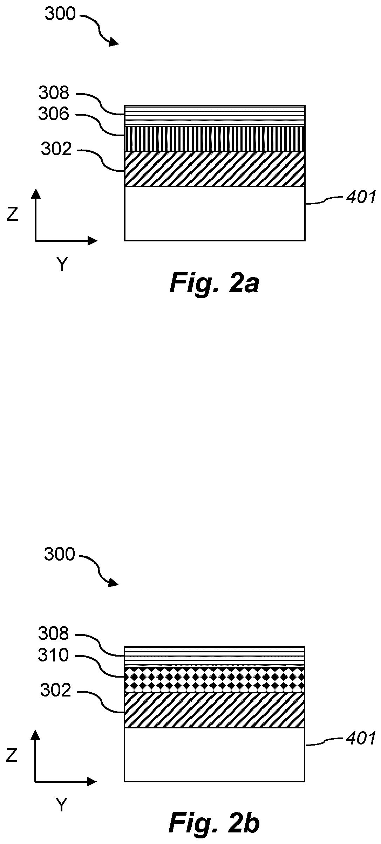

Referring now to Fig. 2a, an approach for forming a contact for a DRAM is shown according to the illustrative example. The contact 300 is structurally and compositionally similar to that of the contact 100 of the present invention. The contact 300 comprises a source/drain region 401 on which a first layer 302 is arranged on. On top of the first layer 302, a third layer 306 is arranged. A capping layer 308 is subsequently arranged on the third layer 306. Hence, the only difference with respect to the present invention is that a second layer comprising a silicon layer doped with phosphorus, Si:P layer is omitted in the contact 300 in accordance with the illustrative example.

Referring now to Fig. 2b, the illustrative example further comprises performing an anneal whereupon the third layer 306 reacts with the underlying first layer 302 and thereby forms a Sc_{1-x-y}SiₓP_{y} layer 310. In the illustrative example, the formation of the Sc_{1-x-y}SiₓP_{y} layer 310 involves absorption of phosphorus dopants from the first layer 302 into the third layer 306. As discussed above, the phosphorus dopants of the first layer may be active. Hence, the absorption of active phosphorus dopants by the third layer 306 results in an interface (formed between the first layer 302 and the third layer 306) being deficient in active phosphorus dopants. In contrast, the present invention is based on the insight that in order to avoid, or at least mitigate, absorption of active phosphorus dopants from the first layer 102 into the third layer 106 during DRAM (first) anneal, a second layer 104 comprising a silicon layer doped with a concentration of at least 4% phosphorus is used to react with the third layer 106 for forming the ternary phase ScSiₓP_{y} layer 110 with cubic crystalline structure/symmetry. The formation of said ScSiₓP_{y} layer 110 entails absorption of phosphorus dopants from the second layer 104 rather than from the first layer 102. Thus, a high concentration of active phosphorus dopants may be maintained in the active interface region defined by the first layer 102 and the ScSiₓP_{y} layer 110. As such, a comparably thin Schottky barrier may be formed and thereby a lower contact resistivity may be obtained. It should be noted that the second layer 104 need not comprise active phosphorus dopants. The main purpose of the phosphorus dopants in the second layer 104 is to be, preferably completely, absorbed by/supplied to the third layer 106 when forming the ScSiₓP_{y} layer 110 and hence prevent active dopants being absorbed/supplied from the first layer 102 into the third layer 106.

With further reference to Fig. 2b, it is thus understood that the active interface region (formed between the first layer 302 and the ScSiₓP_{y} layer 310) of the contact 300 in accordance with the illustrative example comprises comparably less active dopants than that of the present contact 100. The first layer 302 and the ScSiₓP_{y} layer 310 may form a metal-semiconductor junction, and more specifically a Schottky barrier. The deficiency of active dopants in the active interface region implies an increase in the thickness of the Schottky barrier which in turns reduces the transmission probability for the free carriers. Hence, the contact resistivity is disadvantageously high.

The layers of the contact 100 as illustrated in the figures may be formed of the materials as discussed in various levels above. Preferably, the first layer 102 comprises a silicon layer doped with phosphorus, Si:P layer, the second layer 104 a silicon layer doped with phosphorus, Si:P layer wherein a phosphorus concentration of the second layer is at least 4%, the third layer 106 scandium, and a capping layer a material comprising a nitride and configured to prevent oxidation of the third layer. Preferably, the first layer 102 has a thickness being 40 nm, the second layer 104 8 nm, the third layer 106 8 nm. Preferably, the ScSiₓP_{y} layer 310 has a thickness, after a first anneal, being 15 nm.

## Claims

1. A method for forming a contact (100) for a semiconductor device, the contact (100) being an electrical contact to a source/drain region (201) of a transistor (200), the source/drain region (201) comprising silicon, the method comprising:
forming a first layer (102) on the source/drain region (201), the first layer (102) comprising at least one of:
a silicon layer doped with phosphorus, Si:P layer;
a silicon layer doped with antimony, Si:Sb layer;
a silicon layer doped with arsenic, Si:As layer;
forming a second layer (104) on top of the first layer (102), the second layer (104) comprising a silicon layer doped with phosphorus, Si:P layer, a phosphorus concentration of the second layer (104) being at least 4%;
forming a third layer (106) on top of the second layer (104), the third layer (106) comprising scandium;
forming a capping layer (108) above the third layer (106), wherein the capping layer (108) comprises a nitride;
performing a first anneal at an anneal temperature above 500°C during an anneal time being at least one hour, the first anneal being performed after said act of forming the capping layer (108).

2. The method according to claim 1, wherein the phosphorus concentration of the second layer (104) is in a range of 4-15%.

3. The method according to any one of the preceding claims, wherein a phosphorus concentration of a Si:P layer of the first layer (102) is within 2-4%.

4. The method according to any one of the preceding claims, wherein the anneal temperature of the first anneal is above 550°C and anneal time of the first anneal is at least 1 h.

5. The method according to any one of the preceding claims, wherein a thickness of the second layer (104) is at least 2 nm.

6. The method according to any one of the preceding claims, wherein the first and second layers (102, 104) are epitaxially grown.

7. The method according to any one of the preceding claims, further comprising:
performing a second anneal subsequent to the first anneal, wherein the second anneal is performed at an anneal temperature above 800°C during an anneal time being between 1 ms and 10 s.

8. The method according to any one of the preceding claims, wherein the transistor (200) comprises a fin structure (204), the source/drain region (201) being in contact with an end surface (206) of the fin structure (204).

9. The method according to any one of the preceding claims, wherein the first anneal is performed after forming, on a same substrate (202) as the transistor (200), a dynamic random access memory cell, DRAM cell (1000).

10. The method according to any of the preceding claims, wherein the third layer (106) is formed by conformal deposition.

11. A dynamic random-access memory cell, DRAM cell, (1000) comprising a transistor and a contact (100), the contact (100) being an electrical contact to a source/drain region (201) of the transistor (200), the source/drain region (201) comprising silicon, the contact (100) comprising:
a first layer (102) on the source/drain region (201), the first layer (102) comprising at least one of:
a silicon layer doped with phosphorus, Si:P layer;
a silicon layer doped with antimony, Si:Sb layer;
a silicon layer doped with arsenic, Si:As layer;
**characterised in that** the contact further comprises:
a scandium silicon phosphide layer (110) having a ternary phase with a cubic crystalline structure on top of the first layer (102).

12. The contact (100) according to claim 11, wherein the scandium silicon phosphide layer (110) has a composition Sc_{1-x-y}SiₓP_{y} wherein y/(x+y) is greater than 4%.

13. The contact according to any one of claims 11-12, wherein the transistor (200) comprises a fin structure (204), the source/drain region (201) being in contact with an end surface (206) of the fin structure (204).

## Patentansprüche

1. Verfahren zum Bilden eines Kontakts (100) für ein Halbleiterbauelement, wobei der Kontakt (100) ein elektrischer Kontakt mit einer Source-/Drain-Region (201) eines Transistors (200) ist, wobei die Source-/Drain-Region (201) Silizium umfasst, wobei das Verfahren umfasst:
Bilden einer ersten Schicht (102) in der Source-/Drain-Region (201), wobei die erste Schicht (102) mindestens eines umfasst von:
einer mit Phosphor dotierten Siliziumschicht, Si:P-Schicht;
einer mit Antimon dotierten Siliziumschicht, Si:Sb-Schicht;
einer mit Arsen dotierten Siliziumschicht, Si:As-Schicht;
Bilden einer zweiten Schicht (104) auf der ersten Schicht (102), wobei die zweite Schicht (104) eine mit Phosphor dotierte Siliziumschicht, Si:P-Schicht umfasst, wobei eine Phosphorkonzentration der zweiten Schicht (104) mindestens 4 % beträgt;
Bilden einer dritten Schicht (106) auf der zweiten Schicht (104), wobei die dritte Schicht (106) Scandium umfasst;
Bilden einer Deckschicht (108) über der dritten Schicht (106), wobei die Deckschicht (108) ein Nitrid umfasst;
Ausführen eines ersten Ausglühens bei einer Ausglühtemperatur von mehr als 500 °C während einer Ausglühzeit, die mindestens eine Stunde dauert, wobei das erste Ausglühen nach dem Schritt des Bildens der Deckschicht (108) ausgeführt wird.

2. Verfahren nach Anspruch 1, wobei die Phosphorkonzentration der zweiten Schicht (104) in einem Bereich von 4 bis 15 % liegt.

3. Verfahren nach einem der vorhergehenden Ansprüche, wobei eine Phosphorkonzentration einer Si:P-Schicht der ersten Schicht (102) zwischen 2 und 4 % liegt.

4. Verfahren nach einem der vorhergehenden Ansprüche, wobei die Ausglühtemperatur des ersten Ausglühens mehr als 550 °C beträgt und die Ausglühzeit des ersten Ausglühens mindestens 1 Std. dauert.

5. Verfahren nach einem der vorhergehenden Ansprüche, wobei eine Dicke der zweiten Schicht (104) mindestens 2 nm beträgt.

6. Verfahren nach einem der vorhergehenden Ansprüche, wobei die erste und die zweite Schicht (102, 104) epitaktisch gezogen werden.

7. Verfahren nach einem der vorhergehenden Ansprüche, ferner umfassend:
Ausführen eines zweiten Ausglühens nach dem ersten Ausglühen, wobei das zweite Ausglühen bei einer Ausglühtemperatur von mehr als 800 °C während einer Ausglühzeit zwischen 1 ms und 10 s ausgeführt wird.

8. Verfahren nach einem der vorhergehenden Ansprüche, wobei der Transistor (200) eine Finnenstruktur (204) umfasst, wobei die Source-/Drain-Region (201) in Kontakt mit einer Endfläche (206) der Finnenstruktur (204) steht.

9. Verfahren nach einem der vorhergehenden Ansprüche, wobei das erste Ausglühen nach dem Bilden einer dynamischen Arbeitsspeicherzelle, DRAM-Zelle (1000), auf dem gleichen Substrat (202) wie der Transistor (200) ausgeführt wird.

10. Verfahren nach einem der vorhergehenden Ansprüche, wobei die dritte Schicht (106) durch konforme Abscheidung gebildet wird.

11. Dynamische Arbeitsspeicherzelle, DRAM-Zelle (1000), umfassend einen Transistor und einen Kontakt (100), wobei der Kontakt (100) ein elektrischer Kontakt mit einer Source-/Drain-Region (201) des Transistors (200) ist, wobei die Source-/Drain-Region (201) Silizium umfasst, wobei der Kontakt (100) umfasst:
eine erste Schicht (102) in der Source-/Drain-Region (201), wobei die erste Schicht (102) mindestens eines umfasst von:
einer mit Phosphor dotierten Siliziumschicht, Si:P-Schicht;
einer mit Antimon dotierten Siliziumschicht, Si:Sb-Schicht;
einer mit Arsen dotierten Siliziumschicht, Si:As-Schicht;
**dadurch gekennzeichnet, dass** der Kontakt ferner umfasst:
eine Scandium-Silizium-Phosphid-Schicht (110), die eine ternäre Phase mit einem kubischen Kristallsystem auf der ersten Schicht (102) aufweist.

12. Kontakt (100) nach Anspruch 11, wobei die Scandium-Silizium-Phosphid-Schicht (110) eine Sc_{1-x-y}SiₓP_{y}-Zusammensetzung aufweist, wobei y/(x+y) größer als 4 % ist.

13. Kontakt nach einem der Ansprüche 11 bis 12, wobei der Transistor (200) eine Finnenstruktur (204) umfasst, wobei die Source-/Drain-Region (201) in Kontakt mit einer Endfläche (206) der Finnenstruktur (204) steht.

## Revendications

1. Procédé de formation d'un contact (100) pour un dispositif à semiconducteur, le contact (100) étant un contact électrique avec une région de source/drain (201) d'un transistor (200), la région de source/drain (201) comprenant du silicium, le procédé comprenant :
la formation d'une première couche (102) sur la région de source/drain (201), la première couche (102) comprenant au moins une parmi :
une couche de silicium dopée au phosphore, couche Si:P ;
une couche de silicium dopée à l'antimoine, couche Si:Sb ;
une couche de silicium dopée à l'arsenic, couche Si:As ;
la formation d'une deuxième couche (104) sur la première couche (102), la deuxième couche (104) comprenant une couche de silicium dopée au phosphore, couche Si:P, une concentration en phosphore de la deuxième couche (104) étant d'au moins 4 % ;
la formation d'une troisième couche (106) sur la deuxième couche (104), la troisième couche (106) comprenant du scandium ;
la formation d'une couche de recouvrement (108) au-dessus de la troisième couche (106), dans lequel la couche de recouvrement (108) comprend un nitrure ;
la réalisation d'un premier recuit à une température de recuit supérieure à 500°C pendant une durée de recuit étant d'au moins une heure, le premier recuit étant réalisé après ladite étape de formation de la couche de recouvrement (108).

2. Procédé selon la revendication 1, dans lequel la concentration en phosphore de la deuxième couche (104) est comprise dans une plage de 4 à 15 %.

3. Procédé selon une quelconque des revendications précédentes, dans lequel une concentration en phosphore d'une couche Si:P de la première couche (102) est comprise entre 2 et 4 %.

4. Procédé selon une quelconque des revendications précédentes, dans lequel la température de recuit du premier recuit est supérieure à 550°C et la durée de recuit du premier recuit est d'au moins 1 h.

5. Procédé selon une quelconque des revendications précédentes, dans lequel une épaisseur de la deuxième couche (104) est d'au moins 2 nm.

6. Procédé selon une quelconque des revendications précédentes, dans lequel les première et deuxième couches (102, 104) sont formées par croissance épitaxiale.

7. Procédé selon une quelconque des revendications précédentes, comprenant en outre :
la réalisation d'un deuxième recuit après le premier recuit, dans lequel le deuxième recuit est effectué à une température de recuit supérieure à 800 °C pendant une durée de recuit comprise entre 1 ms et 10 s.

8. Procédé selon une quelconque des revendications précédentes, dans lequel le transistor (200) comprend une structure d'ailette (204), la région de source/drain (201) étant en contact avec une surface d'extrémité (206) de la structure d'ailette (204).

9. Procédé selon une quelconque des revendications précédentes, dans lequel le premier recuit est effectué après la formation, sur un même substrat (202) que le transistor (200), d'une cellule de mémoire vive dynamique, cellule DRAM (1000).

10. Procédé selon une quelconque des revendications précédentes, dans lequel la troisième couche (106) est formée par dépôt conforme.

11. Cellule de mémoire vive dynamique, cellule DRAM (1000), comprenant un transistor et un contact (100), le contact (100) étant un contact électrique avec une région de source/drain (201) du transistor (200), la région de source/drain (201) comprenant du silicium, le contact (100) comprenant :
une première couche (102) sur la région de source/drain (201), la première couche (102) comprenant au moins une parmi :
une couche de silicium dopé au phosphore (couche Si:P) ;
une couche de silicium dopé à l'antimoine (couche Si:Sb) ;
une couche de silicium dopé à l'arsenic (couche Si:As) ;
**caractérisé en ce que** le contact comprend en outre :
une couche de phosphure de scandium-silicium (110) présentant une phase ternaire à structure cristalline cubique sur la première couche (102).

12. Contact (100) selon la revendication 11, dans lequel la couche de phosphure de scandium-silicium (110) présente une composition Sc_{1-x-y}SiₓP_{y} dans lequel y/(x+y) est supérieur à 4 %.

13. Contact selon une quelconque des revendications 11 et 12, dans lequel le transistor (200) comprend une structure d'ailette (204), la région de source/drain (201) étant en contact avec une surface d'extrémité (206) de la structure d'ailette (204).
